# EUROPEAN PATENT APPLICATION

(11) **EP 3 778 674 A1**
(43) Date of publication of application: **17.02.2021**
(21) Application number: 19803425.8
(22) Date of filing: 13.05.2019
(51) Int. Cl.: C08F 220/22, H01L 41/193, H01L 41/318

(54) **NOVEL FERROELECTRIC MATERIAL**

(30) Priority: 14.05.2018 JP 2018092962
(71) Applicant: The School Corporation Kansai University, Suita-shi, Osaka 564-8680 (JP); Osaka Organic Chemical Industry Ltd., Osaka-shi, Osaka 541-0052 (JP)
(72) Inventor: MANAI, Daisuke, Kashiwara-shi, Osaka 582-0020 (JP); MIZUMORI, Tomoya, Kashiwara-shi, Osaka 582-0020 (JP); KABATA, Masayuki, Kashiwara-shi, Osaka 582-0020 (JP); OKUBO, Erina, Kashiwara-shi, Osaka 582-0020 (JP); TAJITSU, Yoshiro, Suita-shi, Osaka 564-8680 (JP)
(74) Representative: Isarpatent
(86) International application number: PCT/JP2019/018865
(87) International publication number: WO 2019/221041

(57) **Abstract**

A polymer for organic ferroelectric materials and an organic ferroelectric materials are disclosed. The polymer is a (meth)acrylic polymer, wherein the polymer comprises one or more (meth)acrylates as main monomer units and one or more (meth)acrylic monomers other than the main monomer units, wherein the main monomer units are (meth)acrylate monomer units having in the side chain thereof a saturated or unsaturated hydrocarbon skeleton linked to the distal end of the oxycarbonyl group, wherein the hydrocarbon skeleton has a hydrogen atom on the β-carbon atom relative to the oxycarbonyl group, and one or more electron withdrawing groups selected from halogen atom, cyano group, oxo group, and nitro group, that bind to the β-carbon atom and/or to one or more carbon atoms distal thereto, substituting for hydrogen atoms thereon, wherein the proportion of the main monomer units is less than 80 mol% of the total (meth)acrylic monomer units.

## Description

### TECHNICAL FIELD

The present invention relates to a ferroelectric material, more specifically to an organic ferroelectric material, in particular a polymer for organic ferroelectric materials based on a (meth)acrylic polymer, as well as to organic ferroelectric materials based thereon.

### BACKGROUND ART

Ferroelectric materials generally possess a piezoelectric property, and it is understood that the greater their remanent polarization is, the stronger piezoelectricity they exhibit. So far, organic piezoelectric materials have been represented by those based on polyvinylidene fluoride (PVDF) (cf., e.g., Patent Documents 1-4). Piezoelectric materials made of polyvinylidene fluoride are utilized in the form of a film in various application including touch sensors, strain gauges, ultrasonic sensors, transducers, acceleration sensors, vibration sensors, microphones, speakers, and the like.

### PRIOR ART DOCUMENTS

### PATENT DOCUMENTS

[Patent Document 1] JP 2008-171935
[Patent Document 2] JP 2010-045059
[Patent Document 3] JP H08-36917
[Patent Document 4] JP H02-284485

### SUMMARY OF INVENTION

### TECHNICAL PROBLEM

Following their synthesis, conventional polymers for organic piezoelectric materials, which are represented by polyvinylidene fluoride, are made into a film form and subjected to a drawing process, by which a certain orientation is given to their tangled polymer chains containing crystallized portions, and then by exposure to a voltage between their opposing surfaces, they obtain piezoelectric property because of the dipoles in their molecules getting oriented. Thus, a process of drawing those polymers is indispensable in the production of conventional organic piezoelectric materials, and installation of drawing equipment and running of drawing process increase the production cost of organic piezoelectric materials. Further, drawing brings about significant fluctuation in film thickness, which becomes less controllable as the thickness of the film is reduced, and thus in particular, it is extraordinarily difficult to produce an extremely thin film with thickness levels of several hundred nm by drawing. Furthermore, as polyvinylidene fluoride is solvent resistant, the solution processing widely employed in other areas cannot be employed in which a thin film is formed by thinly applying a polymer solution on a substrate. Thus, there have been obstacles particularly in production of organic piezoelectric materials in the form of a thin polymer film. Moreover, as it is poorly transparent, there is also a problem that polyvinylidene fluoride cannot be employed for an application where high transparency is required. In addition, conventional organic piezoelectric materials exhibit lower piezoelectric property than inorganic piezoelectric materials.

An objective of the present invention is to provide a novel polymer for organic ferroelectric material. Another objective of the present invention is to provide a polymer for organic ferroelectric material that can be given a ferroelectric property without undergoing drawing. Still another objective of the present invention is to provide a polymer for organic ferroelectric material that can be applied as a solution to form a thin film. Still another objective of the present invention is to provide an organic ferroelectric material having high transparency. A further objective of the present invention is to provide an organic ferroelectric material having a good ferroelectric property compared with conventional organic ferroelectric materials.

### SOLUTION TO PROBLEM

1. A polymer for organic ferroelectric material, the polymer being (meth)acrylic polymer,
   wherein the polymer comprises, as monomers forming the polymer, one or more (meth)acrylates as main monomer units, and one or more (meth)acrylic monomers other than the main monomer units,
   wherein the main monomer units are (meth)acrylate monomer units having in the side chain thereof a saturated or unsaturated hydrocarbon skeleton linked to the distal end of the oxycarbonyl group,
   wherein the hydrocarbon skeleton has
   at least one hydrogen atom on the β-carbon atom relative to the oxycarbonyl group, and
   one or more electron withdrawing groups selected from the group consisting of halogen atom, cyano group, oxo group, and nitro group, that bind to the β-carbon atom and/or to one or more carbon atoms distal thereto, substituting for hydrogen atoms thereon, wherein the halogen atom is selected from fluorine atom and chlorine atom, and
   wherein in the monomer units that form the polymer, the proportion of the main monomer units is less than 80 mol% of the total (meth)acrylic monomer units.
2. The polymer for organic ferroelectric material according to 1 above, wherein the number of carbon atoms of the hydrocarbon skeleton is 2 to 20.
3. The polymer for organic ferroelectric material according to 1 or 2 above, wherein the molecular weight of the (meth)acrylate monomers as the main monomer units is not more than 500.
4. The polymer for organic ferroelectric material according to one of 1 to 3 above, wherein the hydrocarbon skeleton is a saturated hydrocarbon skeleton.
5. The polymer for organic ferroelectric material according to one of 1 to 4 above, wherein the (meth)acrylate monomer as the main monomer unit is 3, 3, 3-trifluoropropyl (meth)acrylate or 3, 3, 3-trichloropropyl (meth)acrylate.
6. The polymer for organic ferroelectric material according to one of 1 to 5 above having a mean molecular weight of 10,000 to 2,000,000.
7. The polymer for organic ferroelectric material according to one of 1 to 6 above in the form of a film.
8. An organic ferroelectric material comprising the polymer for organic ferroelectric material according to 7 above having a remanent polarization.
9. The organic ferroelectric material according to 8 above having a remanent polarization of at least 100 mC/m².

### EFFECTS OF INVENTION

As the polymer for organic ferroelectric material of the present invention can acquire ferroelectric property without the need of a drawing process, it can improve production efficiency through elimination of the process. Further, unlike polyvinylidene fluoride, it can be applied to an object, such as a substrate, in the form of a solution prepared with a solvent, and thus allows employment of spin coating when needed, which enables formation of a thin film with precisely controlled thickness. Thus, it can be advantageously utilized in building various devices, such as sensors that require a high level of precision. Furthermore, as the polymer for organic ferroelectric material of the present invention as well as organic ferroelectric materials prepared therewith have high transparency, they can be used in those applications that require such a high transparency as cannot be met by polyvinylidene fluoride. Moreover, as it has a large remanent polarization comparable to or greater than that of polyvinylidene fluoride, it is very likely to exhibit high piezoelectric property compared with conventional organic ferroelectric materials. Thus, it is considered that it can be employed in a wider range of applications.

### DESCRIPTION OF EMBODIMENTS

In the present invention, the term "polymer for organic ferroelectric material" means an organic polymer having a capacity to obtain a ferroelectric property when subjected to a physical processing of exposure to a voltage.

In the present invention, the term (meth)acrylic polymer means a polymer composed mainly of monomers selected from the group consisting of (meth)acrylic acid derivatives such as (meth)acrylates, (meth)acrylamide and the like, and (meth)acrylic acid, and more specifically means that in all the monomer units that form the polymer, (meth)acrylic monomer units represent, in total, preferably not less than 80 mol%, more preferably not less than 90 mol%, still more preferably not less than 95 mol%, particularly preferably not less than 98%, and, e.g., 100 mol%. Besides, the term "(meth)acrylate" means acrylate and methacrylate alike. The same applies to the term "(meth)acrylic".

The (meth)acrylate monomer unit included as an essential component for the polymer of the present invention to be able to obtain ferroelectric property (herein also referred to as "main monomer unit"), has in its side chain a saturated or unsaturated hydrocarbon skeleton linked to the distal end of the oxycarbonyl group; and the hydrocarbon skeleton has at least one hydrogen atom on the β-carbon atom and one or more electron-withdrawing groups selected from the group consisting of halogen atom, cyano group, oxo group, and nitro group, that bind to the β-carbon atom and/or to one or more carbon atoms distal thereto, substituting for hydrogen atoms thereon, in which the halogen atom is selected from fluorine atom and chlorine atom. Among these halogen atoms, fluorine atom is preferred.

In the present invention, the term "β-carbon atom" means the second carbon atom of the hydrocarbon skeleton moiety linked to the oxycarbonyl group "-C(O)O-" of the side chain, counted from the oxygen side.

In the present invention, the saturated or unsaturated hydrocarbon skeleton moiety, which is linked to the oxycarbonyl group "-C(O)O-" on its oxygen atom side in the side chain of the main monomer unit, may be linear, branched, cyclic, or a combination of such structures, among which a cyclic structural portion may be a saturated or an aromatic ring. The number of carbon atoms forming the hydrocarbon skeleton is preferably 2-20, more preferably 2-15, still more preferably 2-10, even more preferably 2-7, and particularly preferably 3-5. The hydrocarbon skeleton moiety may, for example, be ethyl, propyl, isopropyl, butyl, isobutyl, 1-methylpropyl, pentyl, hexyl, 1-methylpentyl, 1-methylhexyl, 4-methylcyclohexyl, and tolyl, though not limited to these.

Insofar as it has at least one hydrogen atom, the β-carbon atom may, in accordance with the number of remaining hydrogen atoms on it, have all or part of the rest of the hydrogen atoms substituted by some of the electron withdrawing groups mentioned above. Further, the electron withdrawing groups may substitute all or part of hydrogen atoms on each carbon atom locating on the distal side to the β-carbon atom in the side chain.

In the present invention, though there is no particular upper limit to the molecular weight of the monomers that correspond to the main monomer units, it is preferably not more than 500, more preferably not more than 300, and still more preferably not more than 250.

The polymer for organic ferroelectric material of the present invention may comprise one or more main monomer units.

In the monomer units forming the polymer for organic ferroelectric material of the present invention, the proportion of the main monomer units to all the (meth)acrylic monomer units is less than 80 mol%, and it may be less than 75 mol%, less than 72 mol%, or the like. Though there is no particular lower limit to the molar percentage of the main monomer unites, it is preferably not less than 30 mol%, more preferably not less than 40 mol%, still more preferably not less than 45 mol%, and particular preferably not less than 50 mol%.

In producing the polymer of the present invention, (meth)acrylic monomers other than the main monomer may be employed for tuning (mechanical, electric, chemical) properties of the polymer. Examples of such additional (meth)acrylic monomers for tuning include, but are not limited to, C1-C4 alkyl (meth)acrylates such as methyl (meth)acrylate, ethyl (meth)acrylate, methyl 2-halo(meth)acrylate, ethyl 2-halo(meth)acrylate, wherein the halogen may be fluorine or chlorine, propyl (meth)acrylate, isopropyl (meth)acrylate, n-butyl (meth)acrylate, isobutyl (meth)acrylate, and t-butyl (meth)acrylate; neopentyl (meth)acrylate, ethoxy-ethoxyethyl (meth)acrylate, hydroxy C1-C4 alkyl (meth)acrylates, methoxy C1-C4 alkyl (meth)acrylate, and benzyl (meth)acrylate; (meth) acrylic acid, N-methyl-(meth)acrylamide, N-ethyl-(meth)acrylamide, N-propyl-(meth)acrylamide, N-isopropyl-(meth)acrylamide, N-butoxymethyl-(meth)acrylamide, N-t-butyl-(meth)-acrylamide, N-octyl-(meth)acrylamide, N,N-dimethyl-(meth)acrylamide, N,N-diethyl-(meth)acrylamide, (meth)acryloylmorpholine, diacetone(meth)acrylamide, and the like.

In the case where the polymer of the present invention comprises one or more monomer units other than (meth)acrylic ones, they may also be utilized for tuning the (mechanical, electric, chemical) properties of the polymer of the present invention. Examples of such non-(meth)acrylic monomer units include, but not limited to, monomers having an ethylenic double bond, such vinyl acetate, (meth)acrylonitrile, phenylacrylonitrile, styrene, α-methylstyrene, p-hydroxystyrene, methyl itaconate, ethyl itaconate, vinyl propionate, N-vinylpyrrolidone, N-vinylcaprolactam, N-phenylmaleimide, and the like.

The mean molecular weight of the polymer for organic ferroelectric material of the present invention is preferably in the range of 10,000-1,000,000, more preferably in the range of 10,000-800,000, and still more preferably in the range of 10,000-500,000. It may be set as desired, e.g., in the range of 100,000-400,000, in the range of 200,000-300,000, and the like. Besides, the term "mean molecular weight" as used with the polymer of the present invention means weight-average molecular weight, which can be determined using gel filtration column chromatography (GPC). An example of apparatus that may be used for performing GPC is HLC-8220, mfd. by Tosoh Corporation.

Examples of main monomers that may form the polymer for organic ferroelectric material of the present invention include, but are not limited to, 3,3,3-trifluoropropyl (meth)acrylate, 3,3,3-trichloropropyl (meth)acrylate, 4,4,4-trifluorobutyl (meth)acrylate, 4,4,4-trichlorobutyl (meth)acrylate, 2,2-difluoroethyl (meth)acrylate, 2,2-dichloroethyl (meth)acrylate, 2-cyanoethyl (meth)acrylate, 4-(trifluoromethyl)cyclohexyl (meth)acrylate, and 4-(trichloromethyl)cyclohexyl (meth)acrylate.

The polymer for ferroelectric materials of the present invention can be produced using the component monomers mentioned above by the well-known method for production of poly(meth)acrylate polymers. For polymerization of component monomers, one or more conventional polymerization initiators are preferably employed following a common procedure. Examples of such polymerization initiators include 2,2'-azobisisobutyronitrile, azoisobutyronitrile, azobisdimethylvaleronitrile, benzoyl peroxide, potassium persulfate, ammonium persulfate, benzophenone derivatives, phosphine oxide derivatives, benzoketone derivatives, phenyl thioether derivatives, azide derivatives, diazo derivatives, disulfide derivatives, and the like, of which two or more may be employed together as desired.

Further, in the case where some of the monomers that make up the polymer for organic ferroelectric material mentioned above have a functional group which is not directly involved in the polymerization reaction in the process of polymer formation, the polymer may be provided in a cross-linked form with a proper cross-linking agent that can form covalent bonds by reaction with the functional group. Examples of such functional groups include hydroxyl group, amino group, isocyanate group, and the like.

Specific examples of such monomers having a hydroxyl group include, but are not limited to, 2-hydroxyethyl (meth)acrylate, 2-hydroxypropyl (meth)acrylate, 2-hydroxybutyl (meth)acrylate, 2-hydroxy-1-methylethyl (meth)acrylate, 4-hydroxybutyl (meth)acrylate, 4-hydroxyphenyl (meth)acrylate, 4-hydroxycyclohexyl (meth)acrylate, 1,4-cyclohexanedimethanol (meth)acrylate, 2-hydroxy-3-phenoxypropyl (meth)acrylate, dipentaerythritol penta(meth)acrylate, and polypropylene glycol (meth)acrylate.

Further, specific examples of such monomers having an isocyanate group include, but are not limited to, 2-isocyanatoethyl (meth)acrylate, 3-isocyanatopropyl (meth)acrylate, 2-isocyanato-1-methylethyl (meth)acrylate, 2-(ethoxycarboxyamino)-ethyl (meth)acrylate, 2-butoxy carboxyamino)ethyl (meth)acrylate, 2-(isopropoxy-carboxyamino) ethyl (meth)acrylate, 2-([1-methoxy-2-propoxy]carboxyamino) ethyl (meth)acrylate, and 2-([1-methylpropylideneamino]carboxyamino)ethyl (meth)-acrylate.

Examples of cross-linking agents usable for polymers containing monomer units having a hydroxyl group include those having two or more isocyanate groups. Specific examples of such cross-linking agents include, but are not limited to, 1,6-hexane diisocyanate, 2,2,4-trimethylhexamethylene diisocyanate, 2-methylpentane-1,5-diyl bisisocyanate, 2,4-tolylene diisocyanate, 2,6-tolylene diisocyanate, 1,3-phenylene diisocyanate, 1,4-phenylene diisocyanate, 1,3-xylylene diisocyanate, 1,4-xylylene diisocyanate, 1,5-naphthalene diisocyanate, 3,3'-dimethyl-4,4'-diphenylmethane diisocyanate, 4,4'-diphenylmethane diisocyanate, 3,3'-dimethylphenylene diisocyanate, 4,4'-biphenylene diisocyanate, isophorone diisocyanate, methylenebis(4-cyclohexyl isocyanate), bis(2-isocyanatoethyl) fumarate, 6-isopropyl-1,3-phenyl diisocyanate, 4,4'-diphenylpropane diisocyanate, lysine diisocyanate, 1,3-bis(isocyanatomethyl)cyclohexane, tetramethylxylylene diisocyanate, [(bicyclo[2.2.1]heptane-2,5-diyl)bismethylene] bisisocyanate, 1,3,5-tris-(6-iso-cyanatohexyl)-1,3,5-triazine-2,4,6-(1H, 3H, 5H)-trione, methyltriisocyanato¬isilane, and tetraisocyanatosilane.

Furthermore, as a cross-linking agent for a polymer that contains monomer units having an isocyanate group, one of those compounds having 2 or more hydroxyl groups or 2 or more amino groups, for example, can be employed. Specific examples of such a cross-linking agent include, but are not limited to, ethylene glycol, propylene glycol, 1,3-propanediol, 1,3-butane diol, 1,4-butanediol, 1,5-pentanediol, 1,6-hexanediol, 1,8-octanediol, 1,9-nonanediol, diethylene glycol, dipropylene glycol, neopentyl glycol, glycerol, pentaerythritol, 1,1,1-trimethylolpropane, 1,2,5-hexanetriol, 1,4-cyclohexanediol, hydroquinone, 4,4'-dihydroxy-phenylmethane, 2,2-bis(4-hydroxyphenyl)propane, polypropylene glycol, polyoxyethylene glycol, polyoxypropylenetriol, polyoxypropylene glycol; and trimethylenediamine, hexamethylenediamine, 1,10-aminodecane, ethylene glycol bis(2-aminoethyl)ether, 1,3-bis(aminomethyl)cyclohexane, 1,4-bis(aminomethyl)-cyclohexane, 4,4'-diaminobenzophenone, 3,4'-diaminodiphenyl ether, 4,4'-diaminodiphenyl ether, 3,3'-diaminodiphenylmethane, 4,4'-diaminodiphenylmethane, and 2,7-diaminofluorene.

Cross-linking of the polymer for organic ferroelectric material mentioned above can be performed by a conventional method in accordance with the combination of the cross-linking agent employed and the functional group that is to take part in the bond formation with the cross-linking agent. For example, to produce a cross-linked polymer in a film form, cross-linking is performed preferably by heating and/or by irradiation with energy beam such as ultraviolet light, a cross-linking agent-containing, uncrosslinked polymer that is prepared in the form of a coating film. Any of known methods and conditions may be employed as desired as the method and condition for forming a film, and also as the method and condition for carrying out irradiation with an energy beam.

By application of a voltage between the front and back surfaces of it, e.g., in the form of film, the polymer for organic ferroelectric material of the present invention obtains a large remanent polarization, making an organic ferroelectric material. Unlike polyvinylidene fluoride, it does not need drawing, and can be made into a film form using any one of well-known methods chosen as desired. And as it is not solvent resistant as is polyvinylidene fluoride, the polymer for organic ferroelectric material of the present invention can be prepared as a solution using a proper solvent, which then can be applied to the surface of a substrate, dried, or further baked, into a film. Furthermore, a thin film of it can be prepared very easily by applying it on a substrate as a solution and subjecting it to spin coating. Though there is no particular limitation as to the thickness of a thin film, a thickness of 10-100 µm, for example, can be easily achieved, and so it is applicable to various uses and therefore convenient. Application of a voltage to a film of the polymer for organic ferroelectric material of the present invention can be carried out by the well-known method employed for polyvinylidene fluoride. The remanent polarization of the organic ferroelectric material of the present invention is at least 100 mC/m².

There is no particular limitation as to the shape of the polymer for organic ferroelectric material of the present invention. Namely, it is sufficient that the shape allows the polymer to obtain remanent polarization by application of a voltage (poling treatment). Though the shape of a film mentioned above is a typical one, it is not limited thereto.

### EXAMPLES

While the present invention is described in further detail below with reference examples and working examples, it is not intended that the present invention be limited to the examples.

### [Reference Example 1] Synthesis of 3,3,3-trifluoropropyl methacrylate (3FPMA)

Following the procedure presented below 3FPMA was synthesized.

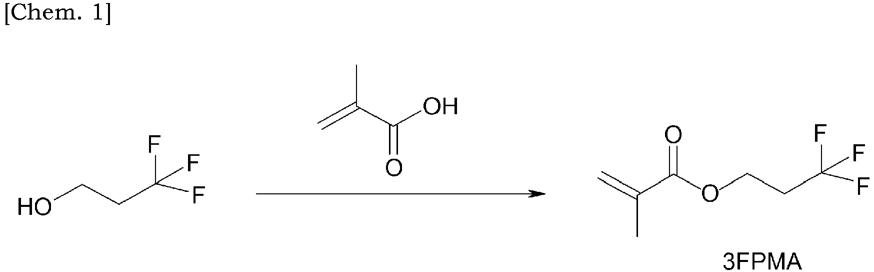

In a 1-L 5-neck glass flask equipped with a reflux condenser, water separator, air intake tube, thermometer and stirrer, 25.0 g of 3,3,3-trifluoropropanol, 18.9 g of methacrylic acid, and 5.36 g of N,N-dimethyl-4-aminopyridine were dissolved in 200 g of dichloroethane, to which was added 44.1 g of 1-(3-dimethylaminopropyl)-3-ethylcarbodiimide hydrochloride with stirring in an ice bath, and stirring was continued for 10 hours. Then, after washing and concentration, purification by distillation under reduced pressure gave 21.9 g of 3,3,3-trifluoropropyl methacrylate (3FPMA) as a clear and colorless liquid. The GPC purity of the clear liquid was 99% (using GC-2014, mfd. by Shimadzu Corporation), and the yield was: 55%.

The peaks ¹H-NMR (JNM-AL300, mfd. by JEOL Ltd.) were as follows.
¹H-NMR (CDCl₃, ppm): 1.94-1.95 (3H, m), 2.44-2.59 (2H, m), 4.38 (2H, t), 5.58-5.62 (1H, m), 6.13-6.14 (1H, m)

### [Reference Example 2] Preparation of Polymer (P1) and its evaluation

### (1) Synthesis of Polymer (P1) (p-3FPMA)

Following the procedure presented below, Polymer (P1) (p-3FPMA) was prepared by polymerizing the 3FPMA synthesized above.

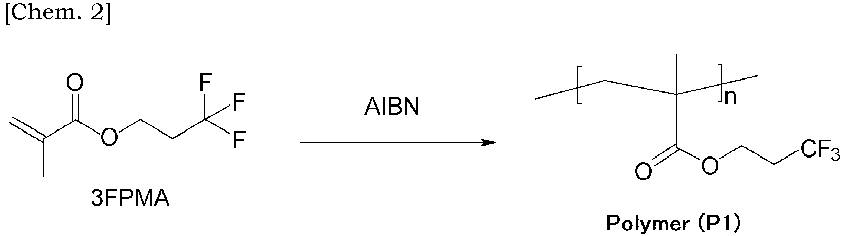

In a 50-mL flask were put 5.0 g of the 3FPMA synthesized above and 12.0 g of butyl acetate. Into the solution thus prepared was introduced nitrogen gas flow for 30 minutes, then the inner temperature was raised to 78 °C, and 0.15 g of 2,2'-azobisisobutyronitrile (AIBN) was added as the reaction initiator. After 6-hour maturation at 80 ± 5 °C, the solution was cooled to 35 °C or lower. The polymerization solution thus obtained was dried at 50 °C under reduced pressure to give Polymer (P1). The weight-average molecular weight (Mw) of this was 16,000 as measured by GPC (using HLC-8820, mfd. by Tosoh Corporation).

### (2) Formation of thin film

Polymer (P1) was dissolved in butyl acetate to prepare a solution (solid content = 55%). This solution was applied to an evaluation substrate equipped with an electrode (mfd. by EHC Co., Ltd.), which then was accelerated on a spin coater (Spin coater 1H-360S, mfd. by Mikasa Co., Ltd.) up to 1,000 rpm over one second, and after kept at this this spinning rate for 10 seconds, stopped over one second to make a film. The evaluation substrate thus prepared was left undisturbed for 30 seconds, dried on a hot plate for 20 minutes at 100 °C, and cooled to room temperature to give an evaluation substrate provided with a thin film of Polymer (P1). The thickness of the thin film was 15.1 µm as measured using a stylus profiling system (Daktak 150, mfd. by Bruker).

### (3) Formation of electrode

Gold or aluminum was vacuum vapor deposited on the thin film of Polymer (P1) on the evaluation substrate.

### (4) Application of voltage and evaluation

For poling treatment, alternating voltage with a frequency of 1 mHz to 1 Hz was applied to the sample thus prepared using a high voltage apparatus (HEOPS-1B30, mfd. by Matsusada Precision Inc.). Further, the response charge from the sample was measured for hysteresis through a charge amplifier, and the remanent polarization and relative permittivity were determined based on the result of measurement.

The criterium for evaluation of remanent polarization is as follows.
⊚: Remanent polarization not less than 2 times that of PVDF (100 mC/m²)
○: Remanent polarization not less than, but less than 2 times, that of PVDF (100 mC/m²).
Δ: Remanent polarization less than that of PVDF (100 mC/m²)
×: No remanent polarization

The result is shown in Table 1. Besides, the detail of PVDF is shown later.

### [Reference Example 3] Preparation of Polymer (P2) and evaluation of its ferroelectric property

### (1) Synthesis of Polymer (P2) (p-3FEMA)

Polymer (P2) (p-3FEMA) was synthesized using 2,2,2-trifluoroethyl methacrylate (3FEMA) (mfd. by Tokyo Chemical Industry Co., Ltd.) as the monomer.

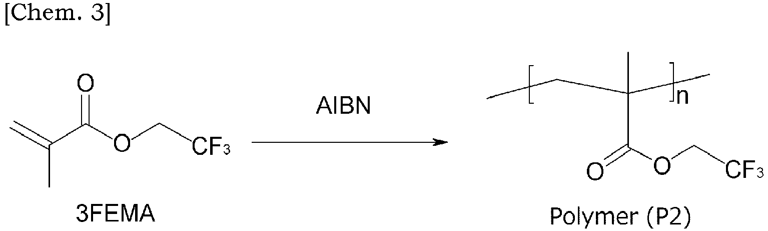

Namely, Polymer (P2) (p-3FEMA) was prepared in the same manner as in Reference Example 2 except that 3FEMA was used instead of 3FPMA. The mean molecular weight (Mw) of it was 15,000.

### (2) Formation of thin film

A thin film was formed on an evaluation substrate following the same procedure as described in Reference Example 2 except that Polymer (P2) was used instead of Polymer (P1). The thickness of this thin film was 14.8 µm.

### (3) Formation of electrode, application of voltage, and evaluation

Formation of an electrode on Polymer (P2), application of a voltage to the polymer, and evaluation of its ferroelectric property, were conducted in the same manner as in Reference Example 2. The result is shown in Table 1.

### [Reference Example 4] Preparation of Polymer (P3) and evaluation of its ferroelectric property

### (1) Synthesis of Polymer (P3) (p-6FMA)

Polymer (P3) was prepared using 1,1,1,3,3,3-hexafluoroisopropyl methacrylate (6FMA) (mfd. by Tokyo Chemical Industry Co., Ltd.) as the monomer.

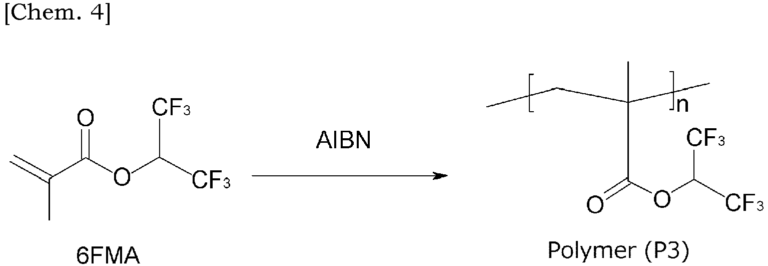

Namely, in a 50-mL flask were put 10.0 g of 6FMA and 24.0 g of butyl acetate to prepare a solution. Nitrogen gas flow was introduced into this solution for 30 minutes, then the inner temperature was raised to 78 °C, and 0.15 g of AIBN was added as the reaction initiator. After 6-hour maturation, the solution was cooled to 35 °C or lower. The polymerization solution thus obtained was dried at 50 °C under reduced pressure to give Polymer (P3) (p-6FMA). The weight-average molecular weight of this polymer was 5,300 as determined by gel permeation chromatography (GPC).

### (3) Formation of thin film

A thin film was formed on an evaluation substrate following the same procedure as described in Reference Example 2 except that Polymer (P3) was used instead of Polymer (P1). The thickness of the thin film was 14.1 µm.

### (4) Formation of electrode, application of voltage, and evaluation

Formation of an electrode on Polymer (P3), application of voltage to the polymer, and evaluation of its ferroelectric property, were conducted in the same manner as in Reference Example 2. The result is shown in Table 1.

### [Comparative Example] PVDF

Electrodes were prepared on the front and back surfaces of 35-µm thick drawn PVDF film (mfd. by Kureha Corporation), and application of a voltage to the polymer and evaluation of its ferroelectric property, were conducted in the same manner as in Reference Example 2. The result showed the ferroelectric property evaluation of 100 mC/m².

### [Reference Example 5] Preparation of Polymer (P4) and evaluation of its ferroelectric property

### (1) Synthesis of Polymer (P4) (p-(3FPMA/BA = 80/20))

Polymer (P4) (p-3FPMA/BA = 80/20) was synthesized using 3,3,3-trifluoropropyl methacrylate (3FPMA) and butyl acrylate (BA) (Tokyo Chemical Industry Co., Ltd.) as the monomers.

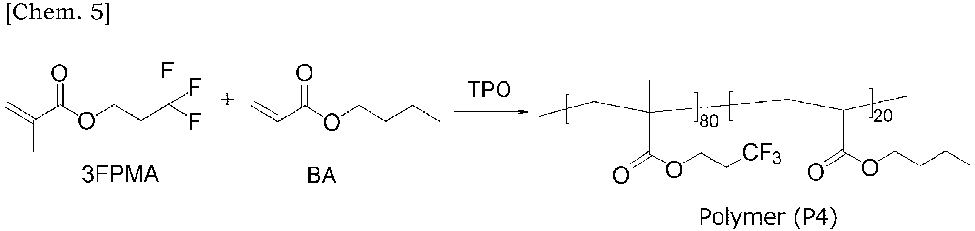

In a glass vessel were put 1.70 g of 3FPMA and 0.30 g of BA, and after nitrogen gas bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (P4). The weight-average molecular weight (Mw) of this was 310,000 as determined by gel permeation chromatography (GPC).

### (2) Formation of thin film

A thin film was formed on an evaluation substrate following the same procedure as described in Reference Example 2 except that Polymer (P4) (solid content = 30%) was used instead of Polymer (P1) and that the spinning rate was changed to 900 rpm. The thickness of the thin film was 12.5 µm.

### (3) Formation of electrode, application of voltage, and evaluation

Formation of an electrode on Polymer (P4), application of voltage to the polymer, and evaluation of ferroelectric property were conducted in the same manner as in Reference Example 2. The result is shown in Table 1.

### [Reference Example 6] Preparation of Polymer (P5) and evaluation of its ferroelectric property

### (1) Synthesis of Polymer (P5) (p-(3FPMA/CNEA = 95/5))

Polymer (P5) (p-(3FPMA/CNEA=95/5)) was synthesized using 3,3,3-trifluoropropyl methacrylate (3FPMA) and 2-cyanoethyl acrylate (CNEA) (mfd. by Tokyo Chemical Industry Co., Ltd.) as the monomers.

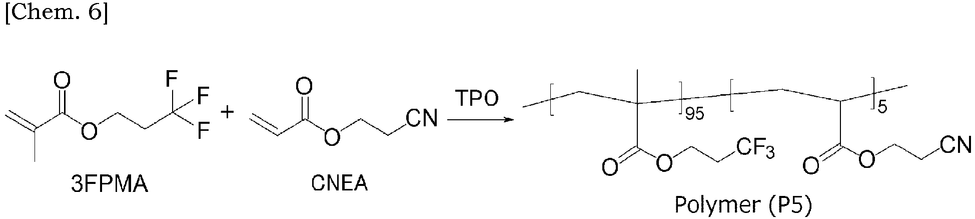

In a glass vessel were put 1.93 g of 3FPMA and 0.07 g of CNEA, and after nitrogen bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (P5). The weight-average molecular weight (Mw) of this was 250,000 as determined by gel permeation chromatography (GPC).

### (2) Formation of thin film

A thin film was formed on an evaluation substrate following the same procedure as described in Reference Example 2 except that Polymer (P5) (solid content = 30%) was used instead of Polymer (P1) and that the spinning rate was changed to 700 rpm. The thickness of the thin film was 13.1 µm.

### (3) Formation of electrode, application of voltage, and evaluation

Formation of an electrode on Polymer (P5), application of voltage to the polymer, and evaluation of ferroelectric property were conducted in the same manner as in Reference Example 2. The result is shown in Table 1.

### [Reference Example 7] Preparation of Polymer (P6) and evaluation of its ferroelectric property

### (1) Synthesis of Polymer (P6) (p-(3FPMA/FMA = 90/10))

Polymer (P6) (p-3FPMA/FMA = 90/10) was synthesized using 3,3,3-trifluoropropyl methacrylate (3FPMA) and methyl 2-fluoroacrylate (FMA) (mfd. by Alfa Aesar) as the monomers.

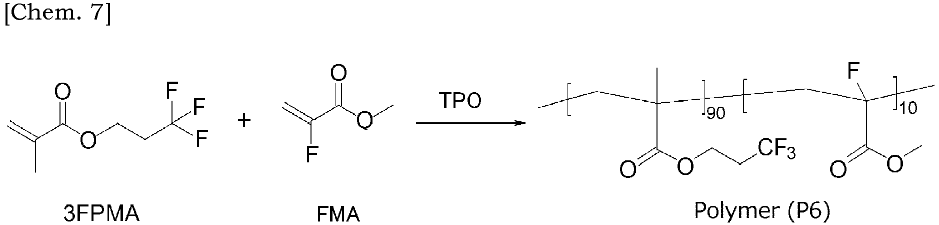

In a glass vessel were put 1.88 g of 3FPMA and 0.12 g of FMA, and after nitrogen bubbling for 30 seconds, 0.02 g of 2,4,6-trimethylbenzoyl-diphenylphosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (P6). The weight-average molecular weight (Mw) of this was 240,000 as determined by GPC.

### (2) Formation of thin film

A thin film was formed on an evaluation substrate following the same procedure as described in Reference Example 2 except that Polymer (P6) (solid content = 30%) was used instead of Polymer (P1) and that the spinning rate was changed to 700 rpm. The thickness of the thin film was 13.3 µm.

### (3) Formation of electrode, application of voltage, and evaluation

Formation of an electrode on Polymer (P6), application of voltage to the polymer, and evaluation of ferroelectric property were conducted in the same manner as in Reference Example 2. The result is shown in Table 1.

### [Reference Example 8] Preparation of Polymer (P7) and evaluation of its ferroelectric property

### (1) Synthesis of Polymer (P7) (p-(3FPMA/HEMA = 99/1))

Polymer (P7) (p-(3FPMA/HEMA = 99/1)) was synthesized using 3,3,3-trifluoropropyl methacrylate (3FPMA) and hydroxyethyl methacrylate (HEMA) (mfd. by Tokyo Chemical Industry Co., Ltd.) as the monomers.

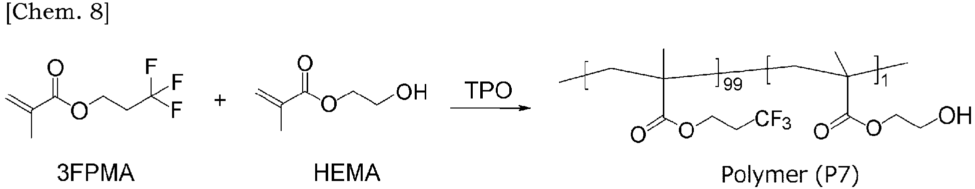

In a glass vessel was put 1.99 g of 3FPMA and 0.01 g of HEMA, and after nitrogen bubbling for 30 seconds, 0.02 g of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (P7). The weight-average molecular weight (Mw) of this was 200,000 as determined by GPC.

### (2) Formation of thin film

In butyl acetate, 2.0 g of Polymer (P7) was dissolved to prepare a solution (solid content = 30%). To this solution was added 0.01 g of 1,3-bis(isocyanatomethyl)cyclohexane (mfd. by Tokyo Chemical Industry Co., Ltd.) as the crosslinking agent and 0.02 mg of catalytic tin (dibutyltin) (product name: Neostann U-100, mfd. by Nitto Kasei Co., Ltd.), and this solution was applied to an evaluation substrate equipped with an electrode, which then was accelerated on a spin coater up to 700 rpm over one second, and after kept at this this spinning rate for 10 seconds, stopped over one second to make a film. The evaluation substrate thus prepared was left undisturbed for 30 seconds, dried on a hot plate for 3 hours at 100 °C, and cooled to room temperature to give an evaluation substrate provided with a thin film of Polymer (P7), now crosslinked. The thickness of the thin film was 12.5 µm as measured using a stylus profiling system above mentioned.

### (3) Formation of electrode, application of voltage, and evaluation

Formation of an electrode on crosslinked Polymer (P7), application of voltage to the polymer, and evaluation of its ferroelectric property were conducted in the same manner as in Reference Example 2. The result is shown in Table 1.

### Results of ferroelectric property evaluation

The results of ferroelectric property evaluation of the polymers of Reference Examples 2-8 were as follows.

[Table 1]
Table 1. Evaluation of ferroelectric property

| Polymers | Permittivity | Remanent polarization |
|---|---|---|
| (P1) | 5.88 | ⊚ |
| (P2) | 2.64 | × |
| (P3) | 2.88 | × |
| (P4) | 6.30 | ○ |
| (P5) | 7.90 | ⊚ |
| (P6) | 8.00 | ⊚ |
| Crosslinked (P7) | 7.00 | ⊚ |

### [Example 1] Preparation of Polymer (A) and evaluation of its ferroelectric property

### (1) Synthesis of Polymer (A) (p-(3FPMA/ACMO = 70:30)

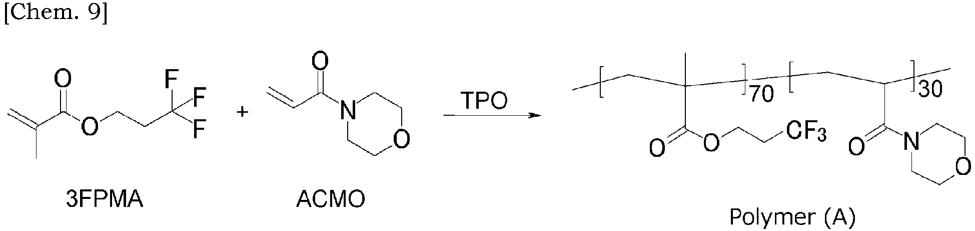

Polymer (A) (p-(3FPMA/ACMO = 70:30) was synthesized using 3,3,3-trifluoropropyl methacrylate (3FPMA) and acryloylmorpholine (ACMO) (KJ Chemicals Corporation) as the monomers by the following method.

In a glass vessel were put 1.50 g of 3FPMA and 0.50 g of ACMO, and after nitrogen gas bubbling for 30 seconds, 0.02 of 2,4,6-trimethylbenzoyl-diphenyl-phosphine oxide (product name: IRGACURE TPO, mfd. by BASF) was added as the polymerization initiator, and the vessel was sealed. The monomer components then were irradiated with ultraviolet light at an illumination intensity of 1.0 mW/cm² for two hours for bulk polymerization of the monomer components to give Polymer (A). The weight-average molecular weight (Mw) of this was 470,000 as determined by gel permeation chromatography (GPC).

### (2) Formation of thin film

Polymer (A) was dissolved in butyl acetate to prepare a solution (solid content = 25%). This solution was applied to an evaluation substrate equipped with an electrode, which then was accelerated on a spin coater up to 700 rpm over one second, and after kept at this this spinning rate for 10 seconds, stopped over one second to make a film. The evaluation substrate thus prepared was left undisturbed for 30 seconds, dried on a hot plate for 20 minutes at 100 °C, and cooled to room temperature to give an evaluation substrate provided with a thin film of Polymer (A). The thickness of this film was 16.0 µm as measured using the stylus profiling system mentioned above.

### (3) Formation of electrode and evaluation of ferroelectric property

An electrode was formed on the sample prepared above and its ferroelectric property was evaluated as in Reference Example 2. The result is shown in Table 2.

### [Example 2] Preparation of Polymer (B) and evaluation of its ferroelectric property

### (1) Synthesis of Polymer (B) (p-(3FPMA/ACMO = 60/40))

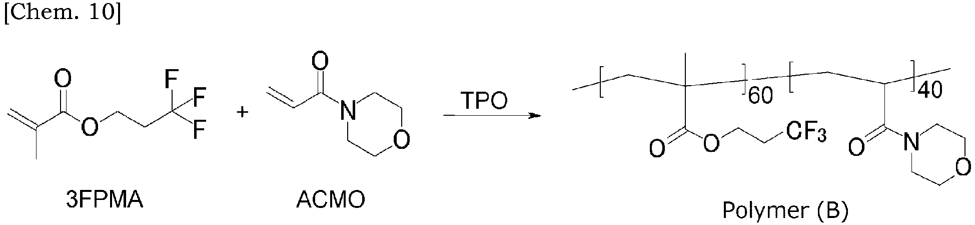

Polymer (B) was synthesized in the same manner as in Example 1 except that the amount of 3FPMA employed was 1.32 g and that of ACMO was 0.68 g. The weight-average molecular weight of this was 570,000 as measured by gel permeation chromatography (GPC).

### (2) Formation of this film and electrode, and evaluation of ferroelectric property

A thin film was formed on an evaluation substrate in the same manner as in Example 1 except that Polymer (B) (solid content = 20%) was used instead of Polymer (A). The thickness of the thin film was 13.5 µm. An electrode was formed on this thin film in the same manner as in Example 1, and its ferroelectric property was evaluated.

### [Example 3] Preparation of Polymer (C) and evaluation of its ferroelectric property

### (1) Synthesis of Polymer (C) (p-(3FPMA/ACMO = 50/50))

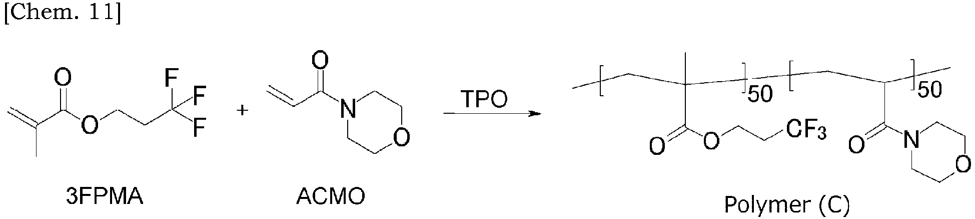

Polymer (C) was prepared in the same manner as in Example 1 except that the amount of 3FPMA was 1.13 g and that of ACMO was 0.87 g. The weight-average molecular weight (Mw) of this was 680,000 as measured by gel filtration chromatography (GPC).

### (2) Formation of thin film and electrode and evaluation of ferroelectric property

A thin film was formed on an evaluation substrate in the same manner as in Example 1 except that Polymer (C) (solid content = 20%) was used instead of Polymer (A) and that the spinning rate was set at 1,000 rpm. The thickness of the thin film was 14.5 µm. An electrode was formed on this thin film in the same manner as in Example 1, and its ferroelectric property was evaluated. The result is shown in Table 2.

### [Example 4] Preparation of Polymer (D) and evaluation of its ferroelectric property

### (1) Synthesis of Polymer (D) (p-(3FPMA/BA = 70/30))

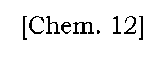

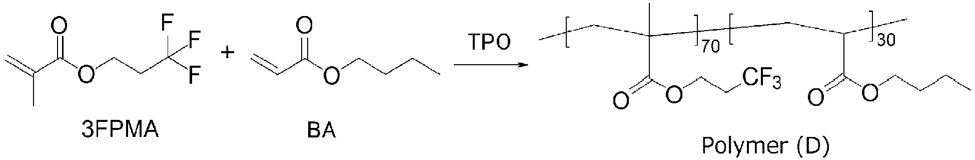

Polymer (D) was prepared as in Example 1 except that that the amount of 3FPMA was 1.54 g and that n-butyl acrylate (BA) was employed instead of acryloylmorpholine (ACMO). The weight-average molecular weight (Mw) of this was 390,000 as measured by gel filtration chromatography (GPC).

### (2) Formation of thin film and evaluation of ferroelectric property

A film was formed subjecting Polymer (D) prepared above to heat pressing at 150 °C and then pressing using a pressing machine set at 20 °C. The thickness was this was measured to be 13.0 µm. An electrode was formed on this thin film in the same manner as in Example 1, and its ferroelectric property was evaluated. The result is shown in Table 2.

The results of ferroelectric property evaluation of the polymers of Examples 1-4 were as follows. Any of the polymers of Examples exhibited a high relative permittivity and a larger remanent polarization than PVDF, indicating a high probability that they have a sufficient piezoelectric property.

### [Table 2]

**Table 2. Evaluation of ferroelectric property**

| Polymers | Permittivity | Remanent polarization |
|---|---|---|
| (A) | 6.00 | ○ |
| (B) | 5.94 | ○ |
| (C) | 5.88 | ○ |
| (D) | 9.00 | ○ |

### INDUSTRIAL APPLICABILITY

As it does not require drawing, which is a preliminary process for obtaining ferroelectric property, the polymer for organic ferroelectric material of the present invention enables simplification of the process for production of ferroelectric materials and easy improvement in production efficiency and cost reduction. Further, as it comes to have a large remanent polarization compared with polyvinylidene fluoride, it is suggested that it would be most likely to achieve a high piezoelectric property. Moreover, as it allows utilization of solution process, and therefore easy achievement of high precision thin film production, it is highly useful in a wide variety of applications such as sensors, and the like. In particular, since it is highly transparent, it can be applied to such usages as polyvinylidene fluoride cannot be employed for due to its lack of transparency.

## Claims

1. A polymer for organic ferroelectric material, the polymer being (meth)acrylic polymer,
wherein the polymer comprises, as monomers forming the polymer, one or more (meth)acrylates as main monomer units, and one or more (meth)acrylic monomers other than the main monomer units,
wherein the main monomer units are (meth)acrylate monomer units having in the side chain thereof a saturated or unsaturated hydrocarbon skeleton linked to the distal end of the oxycarbonyl group,
wherein the hydrocarbon skeleton has
at least one hydrogen atom on the β-carbon atom relative to the oxycarbonyl group, and
one or more electron withdrawing groups selected from the group consisting of halogen atom, cyano group, oxo group, and nitro group, that bind to the β-carbon atom and/or to one or more carbon atoms distal thereto, substituting for hydrogen atoms thereon, wherein the halogen atom is selected from fluorine atom and chlorine atom, and
wherein in the monomer units that form the polymer, the proportion of the main monomer units is less than 80 mol% of the total (meth)acrylic monomer units.

2. The polymer for organic ferroelectric material according to claim 1, wherein the number of carbon atoms of the hydrocarbon skeleton is 2 to 20.

3. The polymer for organic ferroelectric material according to claim 1 or 2, wherein the molecular weight of the (meth)acrylate monomers as the main monomer units is not more than 500.

4. The polymer for organic ferroelectric material according to one of claims 1 to 3, wherein the hydrocarbon skeleton is a saturated hydrocarbon skeleton.

5. The polymer for organic ferroelectric material according to one of claims 1 to 4, wherein the (meth)acrylate monomer as the main monomer unit is 3, 3, 3-trifluoropropyl (meth)acrylate or 3, 3, 3-trichloropropyl (meth)acrylate.

6. The polymer for organic ferroelectric material according to one of claims 1 to 5 having a mean molecular weight of 10,000 to 2,000,000.

7. The polymer for organic ferroelectric material according to one of claims 1 to 6 in the form of a film.

8. An organic ferroelectric material comprising the polymer for organic ferroelectric material according to claim 7 having a remanent polarization.

9. The organic ferroelectric material according to claim 8 having a remanent polarization of at least 100 mC/m².
